# EUROPEAN PATENT APPLICATION

(11) **EP 4 459 008 A1**
(43) Date of publication of application: **06.11.2024**
(21) Application number: 23171140.9
(22) Date of filing: 02.05.2023
(51) Int. Cl.: C23C 28/04, C23C 14/06, C23C 28/00, C23C 30/00

(54) **WORKPIECE HAVING A HARD MATERIAL COATING**

(71) Applicant: VOESTALPINE EIFELER VACOTEC GMBH, 40549 Düsseldorf (DE)
(72) Inventor: HOLZAPFEL, Damian, 40549 Düsseldorf (DE); ZIMMERMANN, Uwe, 40549 Düsseldorf (DE)
(74) Representative: Lambsdorff & Lange Patentanwälte Partnerschaft mbB

(57) **Abstract**

A workpiece includes a substrate and a hard material layer disposed over the substrate. The hard material layer includes either (A) a metal nitride layer having a composition (Alₓ,Cr_{y},Ti_{z})N with optionally added alloying elements Nb, Mo, B, Si, the metal nitride layer having an essentially stoichiometric nitrogen ratio; or (B) at least one first metal nitride layer and at least one second metal nitride layer disposed one over the other, the first metal nitride layer having a composition (Alₓ,Cr_{y})N with optionally added alloying elements B, Si, and the second metal nitride layer having a composition (Alₓ,Ti_{z})N with optionally added alloying elements Nb, Mo, Si. The first metal nitride layer and the second metal nitride layer each have an essentially stoichiometric nitrogen ratio.

## Description

### Technical Field

This disclosure relates to a workpiece having a hard material layer formed over a substrate, and in particular to a workpiece used as a tool for machining or forming operations.

### Background

The use of protective coatings on tools for machining, cutting or forming applications is known. Such tools compromise a substrate and a hard material coating to protect the substrate and to improve operational performance.

Several properties of the hard material coating may be important in practice. In many applications, the material of the coating should have a high thermal stability and a low thermal conductivity in order to allow higher machining speeds and longer tool lifetime. Further aspects which may be of importance are a high abrasion resistance and a low surface roughness. Moreover, the protective coating should have excellent adhesion to the substrate in order to avoid chipping. Other aspects, which may be of importance depending on the application, are a high resistance to oxidation, a low defect concentration and low intrinsic stress. In some applications, the hard material coating should have a good suitability for de-coating, allowing the tool to be recoated and used multiple times.

(Al,Cr)N-based coatings are frequently used in the art to reduce the wear and increase the lifetime of a tool. However, the composition (Al,Cr)N is metastable and decomposes at elevated temperatures (about 900°C) into c-CrN and h-AlN. For a high temperature suitability it may therefore be desirable to shift this decomposition to higher temperatures (i.e., to improve the thermal stability of the coating).

Further, it may be desirable to provide a coating showing improved oxidation resistance, reduced thermal conductivity, improved mechanical properties (e.g., hardness and elastic modulus) and high performance in machining or cutting applications at high temperatures.

### Summary

According to an aspect of the disclosure a workpiece comprises a substrate. A hard material layer is disposed over the substrate. The hard material layer includes either (A) a metal nitride layer having a composition (Alₓ,Cr_{y},Ti_{z})N with optionally added alloying elements Nb, Mo, B, Si, the metal nitride layer having an essentially stoichiometric nitrogen ratio. Or it may include (B) at least one first metal nitride layer and at least one second metal nitride layer disposed one over the other, the first metal nitride layer having a composition (Alₓ,Cr_{y})N with optionally added alloying elements B, Si, and the second metal nitride layer having a composition (Alₓ,Ti_{z})N with optionally added alloying elements Nb, Mo, Si, the first metal nitride layer and the second metal nitride layer each having an essentially stoichiometric nitrogen ratio.

According to another aspect of the disclosure a method of manufacturing a workpiece comprising a substrate and a hard material layer disposed over the substrate as described above uses physical vapor deposition and/or chemical vapor deposition to generate the hard material layer over the substrate.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is an illustration of an exemplary tool used for hobbing, showing a sectional view and a perspective view of the tool and an enlarged view of a gear of the tool.
Figure 2 illustrates X-ray diffraction (XRD) diagrams of two examples of hard material layer compositions.
Figures 3A-3D illustrate examples of a hard material layer on a substrate of a workpiece.
Figure 4 illustrates various layer stack architectures in connection with Figures 3A-3D.

### Detailed description

The words "over" or "on" or "beneath" with regard to a part, element or material layer formed or located or disposed or arranged or placed "over" or "on" or "beneath" a surface may be used herein to mean that the part, element, or material layer be located (e.g. placed, formed, arranged, disposed, etc.) "directly on" or "directly under", e.g. in direct contact with, the implied surface. The word "over" or "on" or "beneath" used with regard to a part, element, or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or material layers being arranged between the implied surface and the part, element or material layer.

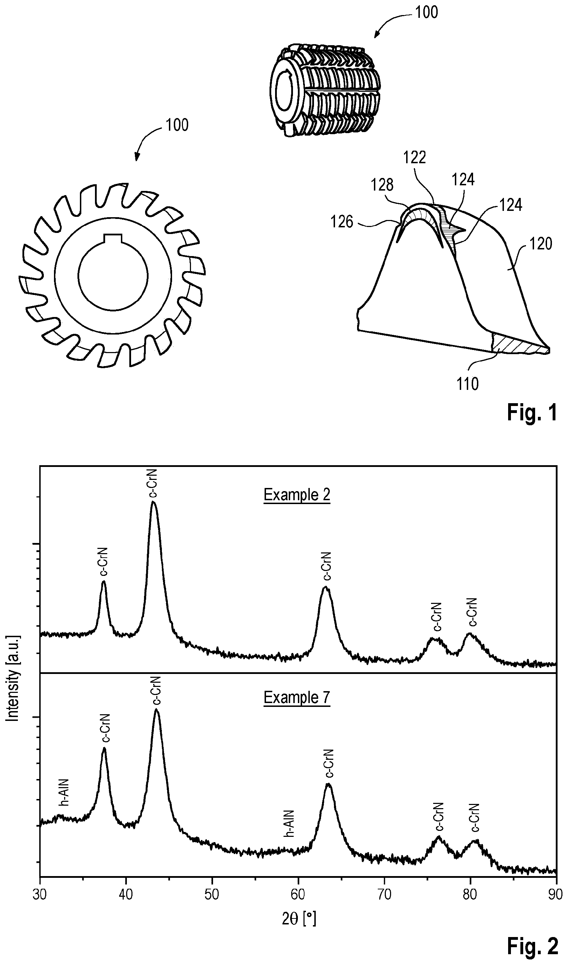

Figure 1 illustrates an exemplary tool or workpiece 100 used for metal cutting operations. In the example shown, the workpiece 100 is a HSS (high speed steel) hob cutter. However, many other tools such as, e.g. ball head cutters, planar or profile cutters, inserts for turning or milling applications, forming dies, etc., may be examples for workpieces 100 disclosed herein. In particular, workpieces 100 described herein may be designed to be used in metal machining or metal cutting applications in which high temperatures may be created and/or are present. Other applications include the machining or cutting of plastics, for example.

The workpiece 100 includes a substrate 110 and a hard material layer 120 disposed over the substrate 110. For example, the substrate 110 may be made of metal, in particular steel, e.g. HSS, cemented carbide, or MC90. The hard material layer 120 is used as a coating to protect the substrate 110 and thereby to extend the lifetime of the workpiece 100 as well as to improve its performance.

During operation the workpiece 100 may suffer wear and/or damage. Figure 1 illustrates damages such as cutting edge rounding 122, flank wear 124, chipping 126 and cratering 128 that can occur over time during operation of the tool.

To avoid such damages, or for other reasons, several aspects related to the hard material layer 120 may be important:

The hard material layer 120 should have a good abrasion resistance. A low surface roughness (R_{z},Rₐ) may be desired. For many applications the defect concentration should be low, and the oxidation resistance (at high operational temperatures) should be high.

For the hard material layer 120, an increase in phase stability (i.e., thermal stability) and a reduction in compressive lattice stress caused by ion bombardment during deposition of the hard material layer may be particularly desirable. In addition, a decrease in thermal conductivity may be particularly desirable because the lower the thermal conductivity, the better the protection of the substrate 110 from thermal damage.

These and other properties are strongly dependent on the chemical and physical parameters of the hard material layer 120, especially on its composition and layer structure.

According to one aspect of the disclosure, the hard material layer 120 may comprise a metal nitride layer having a composition (Alₓ,Cr_{y},Ti_{z})N with optionally added alloying elements Nb, Mo, B, Si.

Here and in the following, a notation is used in which the indices of the elements refer to the content of the element in the so-called metal sub-lattice of the composition, i.e. to the composition term placed in parentheses. That is, the indices (here: x, y, z) of the elements placed in parenthesis add up to 1 (corresponding to 100 at.%) except that optional alloying elements (here: Nb, Mo, B, Si) are added. Hence, the composition (Alₓ,Cr_{y},Ti_{z})N with optionally added alloying elements Nb, Mo, B, Si can also be written as (Alₓ,Cr_{y},Ti_{z},Nbₐ,Mo_{b},B_{c},Si_{d})N, with a+ b + c + d + x + y + z = 1 (and, e.g., a = b = c = d = 0 if no (optional) alloying element is added). It is to be noted that other notations such as those without indices and/or without commas for the metal sub-lattice (e.g., (AlCrTi)N or AlCrTiN for (Alₓ,Cr_{y},Ti_{z})N) are also common in the art. Further, as can be seen from the above, not all elements of the metal sub-lattice need to be metals.

Further, it is to be noted that irrespective of the composition of the metal sub-lattice (i.e., the composition term placed in parenthesis), the composition is essentially stoichiometric, i.e. about 50 at.% (ideally, exactly 50%) of the atoms of the total lattice is N and the rest is the metal sub-lattice. However, as the composition may slightly deviate from stoichiometry, the content of N may be, e.g., in a range of 45 to 55 at.% of the total lattice, which may still be referred to as an "essentially stoichiometric nitrogen ratio".

The effects of the elements of the metal sub-lattice in relation to their content are described below.

Aluminum (Al) is a main group metal. Al forms preferably the wurtzite (hexagonal) AlN structure with nitrogen (also referred to as h-AlN). Al increases the oxidation resistance of the cubic transition metal (TM) aluminum nitride structure (referred to in the following as c-(TM,Al)N structure), as a protective Al₂O₃ scale can form. On the other hand, Al mobility (diffusion) is the main effect for the decomposition of the material system at elevated temperatures.

Al may be, e.g., used in a range between 50 at.% and 72 at.%. Preferably, 65 at.% Al may be used, as this offers the highest hardness. Above 69 at.% Al the thermal stability decreases significantly. Below 50 at.% Al the oxidation resistance decreases.

Chromium (Cr) is a transition metal (TM). Cr forms preferably the cubic CrN structure (also referred to as c-CrN) with nitrogen. Cr increases the oxidation resistance of the c-(TM,Al)N structure, as a protective Cr₂O₃ scale can form. Hexagonal Cr₂N formation is the one of the decomposition products of the material system at elevated temperatures and detrimental for the thermal stability.

Cr may be, e.g., used in a range between 7 at.% and 26 at.%. Above 26 at.% the formation of hexagonal Cr₂N is more detrimental than the desired stabilization of the cubic phase. Preferably about 20 at.% Cr may be used as this offers the highest hardness. Above 24 at.% Cr the thermal stability decreases significantly. Below 10 at.% Cr the wear resistance does not improve.

Titanium (Ti) is a transition metal (TM). Ti forms preferably with nitrogen the cubic TiN structure. Ti strains the atomic lattice and increases the phase stability (as is needed for high temperature operations). On the other hand, Ti decreases the oxidation resistance of the c-(TM,Al)N structure, as a porous TiO₂ scale can form. Ti oxidation can be one of the main effects for coating failure of the material system at elevated temperatures.

Above 24 at.% the oxidation of Ti (during operation) may be more detrimental than the stabilization of the cubic phase (during deposition), i.e. the negative effect may be larger than the positive effect. A preferred range of Ti may be between 5 and 20 at.%. In some examples, about 9 at.% Ti may be used as this offers the highest hardness. In other examples, a specifically preferred range of Ti may be between 12 and 15 at.%, as this still offers a high hardness while providing higher phase stability and still high oxidation resistance at elevated operational temperatures. Above 20 at.% Ti the oxidation resistance decreases slightly, above 24 at.% it may decrease significantly. Below about 1 at.% Ti the wear resistance may not improve by the addition of Ti.

Niobium (Nb) is a transition metal (TM). Nb forms with nitrogen preferably the hexagonal NbN phase. Nb may improve the wear resistance of the c-(TM,Al)N structure drastically, as the hardness increases with Nb addition. Further, Nb increases the ductility of the c-(TM,Al)N structure. Nb increases the thermal stability of c-(TM,Al)N significantly. Nb forms a lubricating oxide.

Preferably, about 3 at.% Nb may be used as this offers the highest hardness. Above 5 at.% Nb the oxidation resistance decreases slightly, above 8 at.% it decreases significantly, and above 12 at.% it decreases too much. The thermal stability, which is increased by Nb, starts to decrease only for Nb addition greater than 10 at.%. Below 1 at.% Nb the wear resistance does not improve by the addition of Nb. A preferred range of Nb may be between 2 and 8 at.%, more preferably between 4 and 5 at.%, as this may allow high hardness, high ductility, and high thermal stability without significant loss of oxidation resistance.

Molybdenum (Mo) is a transition metal (TM). Mo forms preferably the Mo₂N phase with nitrogen. Mo improves the wear resistance of the c-(TM,Al)N structure drastically, as a lubricious oxide of MoO₃ forms that enables less friction during operation. That is, Mo reduces the coefficient of friction, enabling less material adhesion on the hard material layer (i.e., the protective coating).

Preferably, about 6 at.% Mo may be used as this may offer the highest hardness. A specifically preferred range of Mo may be between 4 and 6 at.%, as this offers high hardness and low friction during operation while still providing high thermal stability. Above 12 at.% Mo the thermal stability decreases slightly, above 20 at.% Mo the thermal stability (i.e. phase stability) decreases significantly. Below 1 at.% Mo the wear resistance does not improve by the addition of Mo.

Boron (B) is a main group nonmetal. B forms preferably the hexagonal BN phase with nitrogen. B reduces the crystallite (grain) size, thereby decreasing the thermal conductivity. B improves the wear resistance of the c-(TM,Al)N structure drastically, as the hardness and elastic modulus improve with B addition.

Preferably, about 3 at.% B may be used as this offers the highest hardness. Above 6 at.% B the thermal stability decreases significantly. Below 1 at.% B the wear resistance does not improve by the addition of B. A preferred range of B may be between 1 and 4 at.%, as this offers increased hardness and lowered thermal conductivity virtually without loss of thermal stability. A specifically preferred range of B may be between 2 and 3 at.%.

Silicon (Si) is a main group nonmetal. Si forms preferably the amorphous Si₃N₄ phase with nitrogen. Si improves the oxidation resistance of the c-(TM,Al)N structure drastically, as a mixture of SiO₂ and TiO₂ forms an oxygen diffusion barrier at the surface of the hard material layer. In the bulk hard material layer, the formation of the SiNₓ tissue phase is one of the main effects for enhanced hardness of the c-(TM,Al)N structure. Further, Si reduces the crystallite (grain) size, thereby decreasing the thermal conductivity. Si segregates to grain boundaries, thereby limiting material transport.

Preferably, about 10 at.% Si may be used as this offers the highest hardness for a monolayer. In multi-layer structures, about 2-5 at.% Si may offer best properties. Above 15 at.% Si the oxidation resistance still increases, however the hardness may decrease. Above 20 at.%, the decrease in hardness may be too significant. Below 1 at.% Si the oxidation resistance does not improve by the addition of Si. A preferred range of Si may be between 1 and 15 at.%, as this offers oxidation resistance without significant loss of hardness. A specifically preferred range of Si may be between 2 and 10 at.%.

Nitrogen (N) is a main group nonmetal. It is not part of the metal sub-lattice. N forms preferably a nitride with the here presented metal sub-lattice elements (X) in the X-N and X-N₂ structure. N increases the mechanical properties of the metals.

Coatings as described herein may not form a stoichiometric nitride. It is possible to form nitrides over-stoichiometric (more than 50 at.%) and under-stoichiometric (less than 50 at.%). Both scenarios (not = 50 at.%, i.e. not (ideally) stoichiometric) decrease the mechanical properties and decrease the phase stability as vacancies (metal vacancies if nitrogen is over-stoichiometric and nitrogen vacancies if nitrogen is under-stoichiometric) form. It is also possible to substitute N with oxygen and/or carbon to a small extent.

Preferably, 50 at.% N is used, as this offers the highest elastic modulus and hardness. Above 51 at.% N the thermal stability decreases. Below 49 at.% N the mechanical properties decrease. A preferred range of N may be between 45 and 55 at.%, more preferably between 48 and 52 at.%, as this may promote the elastic modulus and hardness (which, however, can also be affected by other elements as described above).

Table 1 summarizes exemplary chemical compositions of the metal sub-lattice of the hard material layer 120 according to the disclosure (upper and lower limits, preferred upper and lower limits, specifically preferred upper and lower limits).

**Table 1: Exemplary chemical compositions of the hard material layer (in at.%)**

| | **Al** | **Cr** | **Ti** | **Nb** | **Mo** | **B** | **Si** |
|---|---|---|---|---|---|---|---|
| **Upper limit** | 72 | 26 | 24 | 12 | 20 | 6 | 20 |
| **Pref. upper limit** | 69 | 23 | 20 | 8 | 8 | 4 | 15 |
| **Spec. pref. upper limit** | 67 | 20 | 15 | 5 | 6 | 3 | 10 |
| **Spec. pref. lower limit** | 63 | 19 | 12 | 4 | 4 | 2 | 2 |
| **Pref. lower limit** | 58 | 10 | 5 | 2 | 1 | 1 | 1 |
| **Lower limit** | 50 | 7 | 1 | 0 | 0 | 0 | 0 |

In particular in view of Mo and/or B, micro-alloying may be beneficial, i.e. little contents of Mo and/or B are already effective in terms of improving the wear resistance. Therefore, the alloying elements (Nbₐ,Mo_{b},B_{c},Si_{d}) optionally added to the composition (Alₓ,Cr_{y},Ti_{z})N may, e.g., fulfil 0 ≤ a ≤ 0.12 and/or 0.01 ≤ b ≤ 0.20 and/or 0.01 ≤ c ≤ 0.06 and/or 0 ≤ d ≤ 0.20, for example. Any other individual or combined ranges based on any of the above exemplary limits are also possible.

Some elements could optionally be added or used as substitute elements in the metal sub-lattice: V (stabilizes the fcc lattice as well, enhances gliding properties with lubricious oxides), Zr, Y, Hf, Ta, W, and Ni, in general all elements of the 5^{th} and 6^{th} main group of the periodic table.

### EXAMPLES

In Table 2, examples of c-(Al,Cr,Ti)N layer compositions and layer thickness (in um) are set out.

**Table 2: Chemical compositions (in at.%) of examples according to the present disclosure**

| | **Al** | **Cr** | **Ti** | **Nb** | **Mo** | **B** | **Si** | **Layer thickness [µm]** |
|---|---|---|---|---|---|---|---|---|
| **Example 1** | 61 | 14 | 10 | 4 | 5 | 3 | 3 | 3 |
| **Example 2** | 65 | 16 | 10 | 0 | 4 | 2 | 3 | 5 |
| **Example 3** | 62 | 21 | 11 | 0 | 2 | 3 | 1 | 4 |
| **Example 4** | 64 | 20 | 8 | 4 | 0 | 4 | 0 | 3 |
| **Example 5** | 63 | 17 | 8 | 3 | 3 | 4 | 2 | 4 |

In Table 3, examples of c-(Al,Cr,Ti)N layer compositions not according to exemplary Table 1 compositions are set out.

**Table 3: Chemical compositions (in at.%) of examples not falling within all ranges of Table 1**

| | **Al** | **Cr** | **Ti** | **Nb** | **Mo** | **B** | **Si** |
|---|---|---|---|---|---|---|---|
| **Example 6** | **45** | 18 | 15 | 6 | 7 | 3 | 5 |
| **Example 7** | 75 | 8 | 7 | 3 | 3 | 1 | 2 |
| **Example 8** | 55 | **36** | 4 | 0 | 2 | 2 | 1 |
| **Example 9** | 67 | **33** | 0 | 0 | 0 | 0 | 0 |

In Table 3, composition values that fall outside the ranges of Table 1 are in bold. In Example 6 the Al content is lower and in Example 7 it is higher than laid out in Table 1. Examples 8 and 9 exhibit Cr contents higher than laid out in Table 1. The oxidation resistance of the layer of Example 6 was poor. The layer of Example 7 showed relatively low thermal stability. The high Cr content of Example 8 also resulted in a significant decrease in thermal stability. Example 9 consists of cubic phase only, but tool lifetime is decreased in comparison to Example 2.

More specifically, a Titanium-Milling-Test with a Chiron Mill 800 was performed with a milling tool (which is the "workpiece" of the description) having a hard material layer according to Example 2 and a milling workpiece having a hard material layer according to Example 9. The following cutting parameters were used:
Vc = 80 Cutting speed (m/min)
n = 2546 Spindle speed (rev/min)
vf = 509 Feed speed (mm/min)
ap = 5.0 Axial depth of cut (mm)
ae = 3.1 Radial depth of cut (mm)
f = 0.2 Feed per rev (mm/rev)
z = 4 Number of teeth
fz = 0.05 Feed per tooth (mm/tooth)
D = 10 Cutter diameter (mm).

Stopping criteria were set to flank wear > 0.10 mm or fracture. The workpiece of Example 2 exhibited a 74.2 min tool lifetime, while the workpiece of Example 9 exhibited a 49.5 min tool lifetime.

Further, a Tooth-Impact-Test/Fly-hobbing-test was performed with the two above-mentioned workpieces (according to Example 2 and 9) to obtain the cutting performance per tooth: The test yielded a depth of crater wear at 11 m/tooth of 40 µm for the workpiece according to Example 2 and of 110 µm for the workpiece according to Example 9.

Figure 2 illustrates X-ray diffraction (XRD) diagrams (diffractograms) of Examples 2 and 7. Peaks in the diffractograms (intensity in arbitrary units versus twice the theta angle) were characterized with reference to the Crystallography Open Database (COD), the corresponding datasets having the numbers COD-9008619 for c-CrN (which represents the desired cubic/fcc phase) and COD-9008860 for h-AlN (which is the undesired hexagonal phase). As apparent from Figure 2, the hard material layer of Example 2 (upper diffractogram) exhibits cubic phases only, while the hard material layer of Example 7 (lower diffractogram) exhibits both the cubic phase and, to a low extent, the unwanted hexagonal phase.

Generally, a hard material layer in accordance with the disclosure may preferably have only cubic crystalline phases or, optionally, additionally a hexagonal phase (h-AlN) wherein the hexagonal phase fraction is less than 0.5 vol.%, preferably 0.2 vol.% measured by XRD by ratio of peak areas.

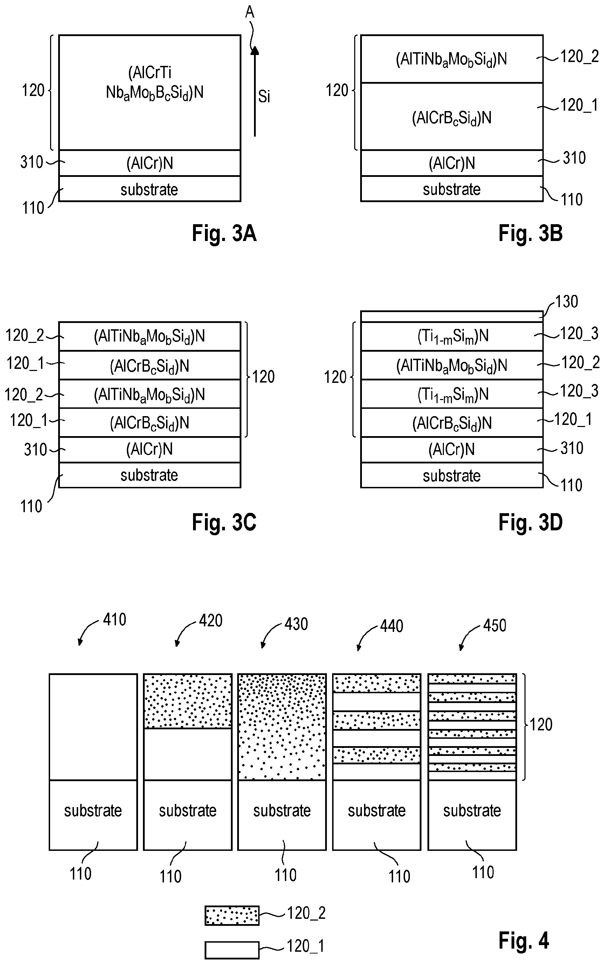

Figures 3A-3D illustrate various illustrative examples of hard material layers 120 which could be used for coating the substrate 110 of a workpiece 100 (see, e.g., Figure 1).

In all examples disclosed herein, the hard material layer 120 is the functional layer of the workpiece 100. In Figure 3A the hard material layer 120 comprises or is a metal nitride layer (in this example, also referred to by the reference sign 120) having a composition (Alₓ,Cr_{y},Ti_{z})N with optionally added alloying elements Nb, Mo, B, Si. The metal nitride layer 120 has an essentially stoichiometric nitrogen ratio.

In some examples, the metal nitride layer 120 may be monolithic, i.e. may have a composition which is constant along the layer thickness. In other examples the metal nitride layer 120 may comprise or be a metal nitride Si-gradient layer. In a metal nitride Si-gradient layer 120, the content d of Si increases along a direction facing away from the substrate 110, see arrow A. For example, d may increase from the bottom to the top of the metal nitride Si-gradient layer 120 over any of the ranges set out in Table 1. In particular, the metal nitride Si-gradient layer 120 may have a composition which is constant along the layer thickness except for Si.

The Si-gradient may be helpful because Si is particularly beneficial at the upper surface of the hard material layer 120 to improve the oxygen diffusion barrier by generating a SiO₂ surface layer which impedes oxygen diffusion into the hard material layer 120. Further, such a SiO₂ surface layer has a very high thermal stability. For example, the Si-gradient may extend over the full thickness or over a partial thickness of the hard material layer 120.

Optionally, an adhesion layer 310 may be disposed between the substrate 110 and the hard material layer 120. The adhesion layer 310 may have a composition
(Al_{x'},Cr_{y'},Ti_{z'},Nb_{a'},Mo_{b'},B_{c'},Si_{d'})N, with 0.00 ≤ x' ≤ 0.72, 0.07 ≤ y' ≤ 1.00, 0.00 ≤ z' ≤ 0.24, 0.00 ≤ a' ≤ 0.12, 0.00 ≤ b' ≤ 0.07, 0.00 ≤ c' ≤ 0.06, and 0.00 ≤ d' ≤ 0.20. (Al_{x'},Cr_{y'})N or (Al_{x'},Cr_{y'},B_{c'})N or (Al_{x'},Cr_{y'},B_{c'},Si_{d'})N. In particular, the adhesion layer 310 may, e.g., be a CrN, (AlCr)N, (AlCrB)N, (AlCrSi)N or (AlCrTiMoBSi)N layer within the above limits.

Specific examples of adhesion layers 310 are given by:
Example Ad1: x'=50, y'=50, z'=a'=b'=c'= d'=0;
Example Ad2: x'=0, y'=100, z'=a'=b'=c'=d'=0;
Example Ad3: x'=40, y'=40, z'=15, b'=5, a'=c'=d'=0;
Example Ad4: x'=40, y'=57, c'=3, z'= a'=b'=d'=0

Adhesion layers 310 of (AlCr)N, (AlCrB)N, (AlCrSi)N or (AlCrTiMoBSi)N within the above limits may have a higher oxidation resistance than a conventional CrN adhesion layer used in the art. Further, these adhesion layers 310 may form a better lattice match between the substrate 110 and the hard material layer 120 than a conventional CrN adhesion layer.

In particular, 0.5 ≤ x' 0.6 and/or
0.4 ≤ y' ≤ 0.5 may be used. In other examples, a metallic Crlayer may be used as an adhesion layer 310.

In the examples of Figure 3A and in all other examples disclosed herein, the hard material layer 120 may have a thickness in a range between 100 nm and 10,000 nm, preferably between 2,000 nm and 4,000 nm. The adhesion layer 310 may have a thickness in a range between 10 nm and 200 nm, preferably about 30 nm.

Referring to Figure 3B, the hard material layer 120 may comprise or be made of one first metal nitride layer 120_1 and one second metal nitride layer 120_2 disposed one over the other. This layer structure may also be referred to as a bi-layer. The first metal nitride layer 120_1 has a composition (Alₓ,Cr_{y})N with optionally added alloying elements B, Si.

**Table 4: Chemical compositions (in at.%) of examples for the first metal nitride layer according to the present disclosure**

| | **Al** | **Cr** | **Ti** | **Nb** | **Mo** | **B** | **Si** |
|---|---|---|---|---|---|---|---|
| **Upper limit** | 72 | 26 | 0 | 0 | 0 | 6 | 20 |
| **Pref. upper limit** | 69 | 23 | 0 | 0 | 0 | 4 | 15 |
| **Spec. pref. upper limit** | 67 | 20 | 0 | 0 | 0 | 3 | 10 |
| **Spec. pref. lower limit** | 63 | 19 | 0 | 0 | 0 | 2 | 2 |
| **Pref. lower limit** | 58 | 10 | 0 | 0 | 0 | 1 | 1 |
| **Lower limit** | 50 | 7 | 0 | 0 | 0 | 0 | 0 |

The second metal nitride layer 120_2 has a composition (Alₓ,Ti_{z})N with optionally added alloying elements Nb, Mo, Si. The first metal nitride layer 120_1 and the second metal nitride layer 120_2 each have an essentially stoichiometric nitrogen ratio.

**Table 5: Chemical compositions (in at.%) of examples for the second metal nitride layer according to the present disclosure**

| | **Al** | **Cr** | **Ti** | **Nb** | **Mo** | **B** | **Si** |
|---|---|---|---|---|---|---|---|
| **Upper limit** | 72 | 0 | 24 | 12 | 20 | 0 | 20 |
| **Pref. upper limit** | 69 | 0 | 20 | 8 | 8 | 0 | 15 |
| **Spec. pref. upper limit** | 67 | 0 | 15 | 5 | 6 | 0 | 10 |
| **Spec. pref. lower limit** | 63 | 0 | 12 | 4 | 4 | 0 | 2 |
| **Pref. lower limit** | 58 | 0 | 5 | 2 | 1 | 0 | 1 |
| **Lower limit** | 50 | 0 | 1 | 0 | 0 | 0 | 0 |

An adhesion layer 310 as described above may be sandwiched between the hard material layer 120 and the substrate 110.

The first metal nitride layer 120_1 may have a thickness in a range between 100 nm and 6,000 nm. The second metal nitride layer 120_2 may have a thickness in a range between 100 nm and 3,000 nm.

Preferably, the layer thickness of the first metal nitride layer 120_1 may be greater than the thickness of the second metal nitride layer 120_2. For example, the thickness of the first metal nitride layer 120_1 may be at least about 2/3 of the total thickness of the hard material layer 120, while the layer thickness of the second metal nitride layer 120_2 may preferably be about 1/3 or less of the total thickness of the hard material layer 120. For example, the thickness of the first metal nitride layer 120_1 may be, e.g., about 2,000 nm, while the layer thickness of the second metal nitride layer 120_2 may be, e.g., about 1,000 nm.

Generally stated, the thickness of the first metal nitride layer 120_1 may be equal to, or greater than, or less than 2 times the thickness of the second metal nitride layer 120_2.

The bi-layer structure of Figure 3B allows the alloying elements Nb, Mo, Si, and B to be placed where they are most effective: The "lubricating" elements Nb and/or Mo may be placed in the (upper) second metal nitride layer 120_2, while the high abrasion resistance of the (lower) first metal nitride layer 120_1 may be further improved by the addition of B, for example. Si may, e.g., be contained only in the (upper) second metal nitride layer 120_2 or in both metal nitride layers 120_1, 120_2, in the latter case with, e.g., the same concentration d in both hard material layers 120_1, 120_2, or with a higher concentration in the (upper) second metal nitride layer 120_2 than in the (lower) first metal nitride layer 120_1.

Further, the (upper) second metal nitride layer 120_2 has a high thermal conductivity, and the (lower) first metal nitride layer 120_1 has a low thermal conductivity. The combination of high and low thermal conductivities produces an anisotropic thermal conductivity which is greater in the lateral direction than in the vertical direction. This protects the substrate 110 from thermal damage and increases the ability of the hard material layer 120 to transfer heat away from the workpiece 100 to the environment by, e.g., the metal chips produced.

Differently stated, the combination of the first metal nitride layer 120_1 and the second metal nitride layer 120_2 may produce many of the desired properties, namely oxidation stability (because of Si), surface lubricity (because of Nb and/or Mo), and abrasion resistance (because of B), as well as the desired anisotropic thermal conductivity of the hard material layer 120.

Referring to Figure 3C, the bi-layer structure of Figure 3B may be extended to a multi-layer structure having a plurality of alternating first and second metal nitride layers 120_1, 120_2. For example, a large number of alternating first and second metal nitride layers 120_1, 120_2 may be stacked on top of each other (only 4 alternating first and second metal nitride layers 120_1, 120_2 are shown for purpose of illustration). That way, a hard layer of low thermal conductivity (first metal nitride layer 120_1) and a lubricating layer of higher thermal conductivity (second metal nitride layer 120_2) will appear alternately on the surface of the workpiece 100 in the course of abrasive tool operation.

In the example of Figure 3C the first metal nitride layer 120_1 may have a thickness in a range between, e.g., 1 nm and 50 nm. Preferably, the thickness of the first metal nitride layer 120_1 may be at least about 3/5 of the layer thickness of the combined first and second metal nitride layer 120_1, 120_2. The second metal nitride layer 120_2 may have a thickness in a range between, e.g., 1 nm and 50 nm. Preferably, the thickness of a second metal nitride layer 120_2 may be at most about 2/5 of the layer thickness of the combined first and second metal nitride layers 120_1, 120_2.

Generally stated, the total thickness of the plurality of first metal nitride layers 120_1 may be equal to, or greater than, or less than 1.5 times the total thickness of the plurality of second metal nitride layers 120_2.

For example, the first and second metal nitride layers 120_1, 120_2 may be designed as nano layers. In this case, the layer thickness of a first metal nitride layer 120_1 may be, e.g., preferably about 3 nm, while the layer thickness of a second metal nitride layer 120_2 may be, e.g., preferably about 2 nm.

The multi-layer structure of Figure 3C greatly reduces thermal conductivity in the vertical direction, since there may be many lattice boundaries that create transition thermal resistance in addition to the intrinsically poor thermal conductivity of the first metal nitride layer 120_1.

In other words, in the multi-layer structure of Figure 3C, hard and poorly thermally conductive layers 120_1 are combined with ductile, lubricating, and well thermally conductive layers 120_2. The more layers there are, the more effective the heat transport anisotropy and the overall decrease of thermal conduction in the vertical direction.

Referring to Figure 3D, the hard material layer 120 may comprise or consist of a plurality of first metal nitride layers 120_1, a plurality of second metal nitride layers 120_2, and at least one and/or a plurality of third metal nitride layers 120_3. The third metal nitride layer(s) 120_3 may be (Ti,Si)N-layer(s) having, e.g., a composition (Ti₁₋ₘ,Siₘ)N, with 0.01 ≤ m ≤ 0.40, preferably 0.01 ≤ m ≤ 0.08, for example. The first metal nitride layers 120_1 and the second metal nitride layers 120_2 may be arranged in alternating order with a third metal nitride layer 120_3 interposed between each first and second metal nitride layer 120_1, 120_2. Alternatively or in addition, a third metal nitride layer 120_3 may be disposed above the alternating first and second metal nitride layers 120_1, 120_2, see Figure 3D. This third metal nitride layer 120_3 may be the top layer of the hard material layer 120 (or may be located between an optional decorative top coating 130 and the uppermost of the first and second metal nitride layers 120_1, 120_2, see the description below).

In other words, the multi-layer structure of Figure 3C may be extended to the multi-layer structure of Figure 3D by providing intermediate third metal nitride layers 120_3 between first and second metal nitride layers 120_1, 120_2. The (optional) intermediate (Ti,Si)N-layers (i.e., the third metal nitride layers 120_3) may have a substantially smaller layer thickness (e.g., by a factor of at least 3, 5, or 10) than the first and the second metal nitride layer 120_1, 120_2.

The intermediate (Ti,Si)N-layers 120_3 have a high hardness, an extremely high oxidation resistance, and a poor thermal conductivity. Therefore, they may act as additional thermal and oxide barriers to improve the overall performance of the hard material layer 120.

In the multi-layer structure of Figure 3D, the first metal nitride layer 120_1 may have a thickness in a range between, e.g., 1 nm and 300 nm. Preferably, the layer thickness may be, e.g., about 100 nm.

The second metal nitride layer 120_2 may have a thickness in a range between, e.g., 1 nm and 300 nm. Preferably, the layer thickness may be, e.g., about 100 nm.

The intermediate third hard metal nitride 120_3 may have a thickness in a range between, e.g., 1 nm and 100 nm. Preferably, the thickness may be, e.g., about 30 nm.

The multi-layer approaches (Figures 3C-3D) may improve the lifetime of the workpiece 100 compared to the bi-layer approach (Figure 3B) with the same total thickness of the hard material layer 120. Further, they may have better and more uniform thermal, oxidation-resistive and lubricating properties. In particular, the high number of layer boundaries effectively enhances the anisotropy of thermal conductivity. Hence, the multi-layer approach (Figures 3C-3D) may better allow combining the desired property of low thermal conductivity with abrasion resistance and thermal stability.

All of the hard material layers 120 described above, as well as the first metal nitride layer 120_1, the second metal nitride layer 120_2, and the third metal nitride layer 120_3, may each have their respective composition according to any of the ranges shown in Table 1 (hard material layer 120) or Table 4 (first metal nitride layer 120_1) or Table 5 (second metal nitride layer 120_2) or as stated above for the third metal nitride layer 120_3. For example, if micro-alloying by B is used, the alloying elements (B_{c},Si_{d}) optionally added to the composition (Alₓ,Cr_{y})N of the first metal nitride layer 120_1 may fulfil 0.01 ≤ c ≤ 0.06 and/or 0 ≤ d ≤ 0.20. For example, if micro-alloying by Mo is used, the alloying elements (Nbₐ,Mo_{b},Si_{d}) optionally added to the composition (Alₓ,Ti_{z})N of the second metal nitride layer 120_2 may fulfil 0 ≤ a ≤ 0.12 and/or 0.01 ≤ b ≤ 0.20 and/or 0 ≤ d ≤ 0.20.

All of the hard material layers 120 described above may be provided with an optional decorative top coating 130 (only shown in Figure 3D). The decorative top coating 130 may comprise or consist of, for example, Ti(O,C,N). TiN, for example, results in a golden coating. With a Ti(O,N) coating, the color can be adjusted by the oxygen content. A Ti(C,N) coating has a pink color. The (optional) decorative top coating 130 may have a layer thickness in a range between, e.g., 10 nm and 1,000 nm. Preferably, the layer thickness may be, e.g., about 100 nm.

Figure 4 illustrates various layer architectures in connection with Figures 3A-3D. The monolithic layer architecture of Figure 3A with constant layer composition is referred to by reference sign 410. The bi-layer architecture of Figure 3B is referred to by reference sign 420. The Si-gradient layer architecture of Figure 3A is referred to by reference sign 430. The multi-layer architectures of Figures 3C and 3D (alternating functional layers 120_1, 120_2 without or with intermediate layers 120_3) are referred to by reference sign 440 or, if configured as nano layers (e.g., with a layer thickness equal to or less than 50, 30 or 10 mm), by reference sign 450. The multi-layer architectures 440, 450 of Figures 3C and 3D are schematic illustrations and may, in practice, include in total more than 10, 50, 100, 300 or 500 metal nitride layers (namely, first metal nitride layers 120_1 and second metal nitride layers 120_2 and (optionally) third metal nitride layers 120_3 (not shown)), for example.

As mentioned above, each of the layer architectures 410, 420, 430, 440, 450 may be provided with a lower adhesion layer 310 between the substrate 110 and the hard material layer 120 and/or an optional decorative top coating 130, which are not shown in Figure 4.

A method of manufacturing a workpiece comprising a substrate and a hard material layer as described above may use a PVD (Physical Vapor Deposition) process to generate the adhesion layer 310, the hard material layer 120, and the top coating 130 over the substrate 110. Specifically, cathodic arc deposition and/or sputtering and/or magnetron deposition may be used, for example. Alternatively or in addition, the process may include CVD (Chemical Vapor Deposition) since, e.g., in particular Si, B, Ti can be added via the gas phase. Further, the process may additionally include ALD (Atomic Laser Deposition), for example.

In some examples, the substrate 110 is preheated before starting PVD and/or CVD. That way, the compressive stress in the hard material layer 120 may be reduced by ensuring good CTE (Coefficient of Thermal Expansion) compensation between the substrate 110 and the adhesion layer 310 and/or the hard material layer 120. On a microscopic scale, the intrinsic compressive stress in the hard material layer 120 may be reduced by aiming for an (ideally) stoichiometric composition, i.e. by providing a low defect concentration.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A workpiece comprising:
a substrate, and
a hard material layer disposed over the substrate, wherein the hard material layer comprises either
(A) a metal nitride layer having a composition (Alₓ,Cr_{y},Ti_{z})N with optionally added alloying elements Nb, Mo, B, Si, the metal nitride layer having an essentially stoichiometric nitrogen ratio; or
(B) at least one first metal nitride layer and at least one second metal nitride layer disposed one over the other, the first metal nitride layer having a composition (Alₓ,Cr_{y})N with optionally added alloying elements B, Si, and the second metal nitride layer having a composition (Alₓ,Ti_{z})N with optionally added alloying elements Nb, Mo, Si, the first metal nitride layer and the second metal nitride layer each having an essentially stoichiometric nitrogen ratio.

2. The workpiece of claim 1, wherein the composition (Alₓ,Cr_{y},Ti_{z})N with optionally added alloying elements Nb, Mo, B, Si fulfils the following requirement:
0.5 ≤ x ≤ 0.72, 0.07 ≤ y ≤ 0.26, 0.01 ≤ z ≤ 0.24.

3. The workpiece of claim 2, wherein the alloying elements (Nbₐ,Mo_{b},B_{c},Si_{d}) fulfil at least one of the following requirements:
0 ≤ a ≤ 0.12, 0.01 ≤ b ≤ 0.20, 0.01 ≤ c ≤ 0.06, 0 ≤ d ≤ 0.20.

4. The workpiece of one of the preceding claims, wherein the metal nitride layer of composition (Alₓ,Cr_{y},Ti_{z})N with optionally added alloying elements Nb, Mo, B is alloyed with Si, wherein a content of Si in the metal nitride layer increases along a direction facing away from the substrate.

5. The workpiece of claim 1, wherein the second metal nitride layer is disposed over the first metal nitride layer, and the thickness of the first metal nitride layer is equal to or greater than 2 times the thickness of the second metal nitride layer.

6. The workpiece of claim 1, wherein
the hard material layer comprises a plurality of the first metal nitride layers and a plurality of the second metal nitride layers,
the first metal nitride layers and the second metal nitride layers are arranged in alternating order, and
the total thickness of the plurality of the first metal nitride layers is equal to or greater than 1.5 times the total thickness of the plurality of the second metal nitride layers.

7. The workpiece of claim 1, wherein
the hard material layer comprises a plurality of the first metal nitride layers, a plurality of the second metal nitride layers, and at least one third metal nitride layer,
the third metal nitride layer having a composition (Ti₁₋ₘ,Siₘ)N, and
the first metal nitride layers and the second metal nitride layers are arranged in alternating order with the third metal nitride layer interposed therebetween or disposed above the alternating first and second metal nitride layers.

8. The workpiece of claim 7, wherein the composition (Ti₁₋ₘ,Siₘ)N fulfils the following requirement:
0.01 ≤ m ≤ 0.40, in particular 0.01 ≤ m ≤ 0.08.

9. The workpiece of claim 1, 5, 6, 7 or 8, wherein alloying elements (B_{c},Si_{d}) added to the composition (Alₓ,Cr_{y})N fulfil at least one of the following requirements:
0.01 ≤ c ≤ 0.06, 0 ≤ d ≤ 0.20.

10. The workpiece of claim 1, 5, 6, 7, 8 or 9, wherein alloying elements (Nbₐ,Mo_{b},Si_{d}) added to the composition (Alₓ,Ti_{z})N fulfil at least one of the following requirements:
0 ≤ a ≤ 0.12, 0.01 ≤ b ≤ 0.20, 0 ≤ d ≤ 0.20.

11. The workpiece of one of the preceding claims, further comprising an adhesion layer disposed between the substrate and the hard material layer, the adhesion layer having a composition (Al_{x'},Cr_{y'},Ti_{z'},Nb_{a'},Mo_{b'},B_{c'},Si_{d'})N, with 0.00 ≤ x' ≤ 0.72,
0.07 ≤ y' ≤ 1.00, 0.00 ≤ z' ≤ 0.24, 0.00 ≤ a' ≤ 0.12, 0.00 ≤ b' ≤ 0.07, 0.00 ≤ c' ≤ 0.06, and 0.00 ≤ d' ≤ 0.20.

12. The workpiece of claim 11, wherein the composition of the adhesion layer fulfils the requirement:
0.50 ≤ x' ≤ 0.60, 0.40 ≤ y' ≤ 0.50.

13. The workpiece of one of the preceding claims, wherein the workpiece is a tool, in particular a hob cutter, a ball head cutter, a planar or profile cutter, an insert for turning or milling applications or a forming die.

14. A method of manufacturing a workpiece comprising a substrate, and a hard material layer disposed over the substrate, wherein the hard material layer comprises either (A) a metal nitride layer having a composition (Alₓ,Cr_{y},Ti_{z})N with optionally added alloying elements Nb, Mo, B, Si, the metal nitride layer having an essentially stoichiometric nitrogen ratio; or (B) at least one first metal nitride layer and at least one second metal nitride layer disposed one over the other, the first metal nitride layer having a composition (Alₓ,Cr_{y})N with optionally added alloying elements B, Si, and the second metal nitride layer having a composition (Alₓ,Ti_{z})N with optionally added alloying elements Nb, Mo, Si, the first metal nitride layer and the second metal nitride layer each having an essentially stoichiometric nitrogen ratio, the method comprising:
using physical vapor deposition and/or chemical vapor deposition to generate the hard material layer over the substrate.
